# EUROPEAN PATENT APPLICATION

(11) **EP 1 956 641 A1**
(43) Date of publication of application: **13.08.2008**
(21) Application number: 06822984.8
(22) Date of filing: 06.11.2006
(51) Int. Cl.: H01L 21/304

(54) **METHOD FOR GRINDING SURFACE OF SEMICONDUCTOR WAFER AND METHOD FOR MANUFACTURING SEMICONDUCTOR WAFER**

(30) Priority: 30.11.2005 JP 2005345531
(71) Applicant: Shin-Etsu Handotai Co., Ltd., Tokyo 100-0004 (JP)
(72) Inventor: ICHIKAWA, Masashi, c/o Shirakawa Plant, Shin-Etsu, Nishishirakawa-gun, Fukushima 96-18061 (JP); OTAKA, Toshiaki, c/o Shirakawa Plant, Shin-Etsu, Nishishirakawa-gun, Fukushima 961-8061 (JP)
(74) Representative: Wibbelmann, Jobst
(86) International application number: PCT/JP2006/322070
(87) International publication number: WO 2007/063677

(57) **Abstract**

The present invention provides a surface grinding method for a semiconductor wafer, which performs surface grinding with respect to a semiconductor wafer sliced into a thin plate shape, wherein at least a cleaning process for removing a heavy metal is performed before carrying out surface grinding of the semiconductor wafer, and a surface grinding process is carried out after performing the cleaning process. As a result, there are provided the surface grinding method and a manufacturing method for a semiconductor wafer, which can effectively reduce a contaminant, which has adhered to a surface of the semiconductor wafer, e.g., a heavy metal such as Cu.

## Description

### TECHNICAL FIELD

The present invention relates to a surface grinding method carried out in a process for manufacturing a semiconductor wafer formed of, e.g., silicon and a manufacturing method for the semiconductor wafer using this surface grinding method, and more particularly to a method for effectively reducing a heavy metal contaminant that adheres during a process for manufacturing a semiconductor substrate (a wafer) .

### BACKGROUND ART

In manufacture of a semiconductor device, when a heavy metal is present in a wafer itself or a fine particle contaminant is present on a wafer surface, performance characteristics of a device may be adversely affected in some cases. A semiconductor substrate (a wafer) used for a semiconductor device is manufactured by mainly processing an ingot block grown by a pulling method (a Czochralski method, a CZ method) into a mirror-finished thin plate. This manufacturing process mainly includes a slicing process for slicing the ingot block into a wafer shape, a chamfering process for chamfering an outer peripheral portion of the sliced wafer, a flattening process for flattening the chamfered wafer by using, e.g., lapping or surface grinding, an etching process for removing a mechanical damage of the flattened wafer, and a polishing process for polishing both sides or a single side of the etched wafer. Further, it also has a heat treatment process, an inspection process, various kinds of cleaning processes, and others.

For cleaning of a semiconductor substrate or pre-cleaning in a thermal oxidation process, pre-cleaning in a CVD process, or cleaning of a semiconductor wafer in, e.g., removal of phosphoric glass, a so-called RCA cleaning method (W. Kern et. al.: RCA Review, 31, p. 187, 1970) for continuously performing (1) NH₄OH+H₂O₂+H₂O mixture immersion processing (1:1:5, 80°C, 10 minutes), (2) pure water rinse, (3) HF+H₂O immersion processing (containing 1% of HF), (4) pure water rinse, (5) HCl+H₂O₂+H₂O mixture immersion processing (1:1:6, 80°C, 10 minutes), (6) pure water rinse, and (7) drying is conventionally adopted as a bases, and a cleaning method that appropriately selects mixture ratios or immersion times of respective processing liquids, a heating temperature, or counterchanges an order of cleaning process using the cleaning liquids in (1), (2), and (3) is general.

Here, it is said that (1) cleaning (SC-1 cleaning) using the NH₄OH+H₂O₂+H₂O mixture is effective in, e.g., removal of foreign particles such as organic materials or removal of heavy metals, (3) HF+H₂O is effective in removal of an oxide film and removal of foreign particles that have adhered to a substrate surface, and (5) cleaning (SC-2 cleaning) using the HCl+H₂O₂+H₂O mixture is effective in removal of heavy metals.

The above-explained cleaning has been conventionally carried out with respect to a wafer subjected to mirror polishing close to a post-process in a manufacturing process of a semiconductor substrate (a wafer) (see, e.g., Japanese Patent Application Laid-open No. 115894-1996). That is because RCA cleaning has a long process and has no problem as long as a mirror-polished wafer is eventually clean, and applying this cleaning to a wafer that is still in the manufacturing process is considered to be substantially unprofitable.

Furthermore, an influence of contamination during processing is generally reduced by subsequent polishing or cleaning. Moreover, device manufacture that does not affect a device is carried out based on various kinds of gettering technologies for trapping a contaminant.

However, in recent years, an influence of a contaminant before polishing, especially in an etching process is becoming important. Since a surface is active in the etching process and an etchant to be used contains a large amount of a contaminant, there is concern that the contaminant may possibly adhere to a wafer surface or diffuse inside the wafer.

In particular, when the wafer surface is contaminated with a heavy metal during processing, a contaminant diffuses into the wafer, and there is a problem of insufficiency of a gettering capability due to a low temperature in a device process, and hence a contamination level of the wafer must be decreased.

### DISCLOSURE OF THE INVENTION

In view of the above-explained problem, it is an object of the present invention to provide a semiconductor wafer surface grinding method, which can effectively reduce a contaminant that has adhered to a wafer, especially a heavy metal, and a manufacturing method for eventually manufacturing a clean high-quality wafer.

To achieve this object, according to the present invention, there is provided a surface grinding method for a semiconductor wafer which performs surface grinding with respect to a semiconductor wafer sliced into a thin plate shape, wherein at least a cleaning process for removing a heavy metal is performed before carrying out surface grinding of the semiconductor wafer, and a surface grinding process is carried out after performing the cleaning process.

Performing the cleaning process for removing a heavy metal before carrying out surface grinding of the semiconductor wafer in this manner enables carrying out surface grinding after removing the heavy metal that has adhered to the wafer. Therefore, in a process having a great mechanical effect to generate heat like surface grinding, a contaminant does not diffuse into the wafer, thus lowering a contamination level of the finally obtained wafer.

In this case, any one or more of SC-1 cleaning, SC-2 cleaning, and cleaning using a mixture containing a citric acid and a hydrogen peroxide solution can be performed as the cleaning process for removing the heavy metal.

Performing any one or more of SC-1 cleaning, SC-2 cleaning, and cleaning using the mixture containing a citric acid and a hydrogen peroxide solution in this manner enables effectively removing the heavy metal before surface grinding.

Moreover, it is preferable to use a wafer etched after slicing as the wafer to be ground.

Since a wafer surface is active in an etching process and an etchant to be used contains a large amount of a contaminant, the contaminant may highly possibly adhere to the wafer surface. When the wafer having the contaminant adhered thereto in the etching process is cleaned to remove the heavy metal and then surface grinding is carried out, the contaminant does not diffuse into the wafer by surface grinding, thus consequently lowering the contamination level of the wafer.

Additionally, according to the present invention, there is provided a manufacturing method for a semiconductor wafer comprising at least a surface grinding process, wherein at least a cleaning process for removing a heavy metal is performed before carrying out surface grinding of the semiconductor wafer, and a surface grinding process is carried out after performing the cleaning process.

Performing the cleaning process for removing the heavy metal before carrying out surface grinding of the semiconductor wafer in this manner enables carrying out surface grinding after removing the heavy metal that has adhered to the wafer. Therefore, the contaminant does not diffuse into the wafer by surface grinding, thereby manufacturing the wafer having the low contamination level.

In this case, any one or more of SC-1 cleaning, SC-2 cleaning, and cleaning using a mixture containing a citric acid and a hydrogen peroxide solution can be performed as the cleaning process for removing the heavy metal.

Performing any one or more of SC-1 cleaning, SC-2 cleaning, and cleaning using the mixture of a citric acid and a hydrogen peroxide solution enables effectively removing the heavy metal before surface grinding and manufacturing the wafer having the low contamination level without diffusing the heavy metal into the wafer during surface grinding.

Further, it is preferable to use a wafer which is etched after slicing as the wafer to be ground.

Since the wafer surface is active in the etching process and an etchant to be used contains a large amount of a contaminant, the contaminant may highly possibly adhere to the wafer surface. Cleaning the wafer to which the contaminant has adhered in the etching process to remove the heavy metal and then performing surface grinding enables manufacturing the wafer having the low contamination level without diffusing the contaminant into the wafer by surface grinding.

Further, it is preferable that at least a polishing process for polishing the semiconductor wafer is performed after carrying out the surface grinding process, and a cleaning process is carried out after performing the polishing process.

When at least the polishing process for polishing the semiconductor wafer is performed after the surface grinding process after cleaning and the cleaning process, e.g., RCA cleaning is carried out after the polishing process, the wafer which is superior in a flatness degree and has the low contamination level can be assuredly manufactured.

As explained above, according to the present invention, there are provided the surface grinding method and the manufacturing method for a semiconductor wafer, the methods being characterized in that the surface grinding process is carried out after the cleaning process for removing a heavy metal is performed to lower a contamination level of the heavy metal. Performing cleaning before surface grinding in this manner enables effectively removing the heavy metal, which has adhered to the wafer, thus decreasing a possibility that the heavy metal diffuses into the wafer by the subsequent surface grinding process having a great mechanical effect. Therefore, a high-quality wafer having a high cleaning degree can be finally manufactured.

### BRIEF DESCRIPTION OF THE DRAWINGS

FIG. 1 is a schematic view for explaining an example of a surface grinding method and a manufacturing method for a semiconductor wafer according to the present invention;
FIG. 2 is a graph showing a result of measuring a Cu impurity concentration on a surface with respect to each of wafers according to Examples 1, 2 and Comparative Examples 1, 2 (an ordinate represents a relative value);
FIG. 3 is a graph showing a result of measuring a Cu impurity concentration on a surface with respect to each of wafers according to Example 3 and Comparative Examples 3, 4 (an ordinate represents a relative value); and
FIG. 4 is a graph showing a result of measuring a Cu impurity concentration on a surface with respect to a wafer subjected to a lapping process and a wafer subjected to surface grinding process as a flattening process (an ordinate represents a relative value).

### BEST MODE(S) FOR CARRYING OUT THE INVENTION

Although the present invention will now be explained hereinafter in detail, the present invention is not limited to this description.

In manufacture of a semiconductor wafer, lapping for the purpose of flattening a sliced wafer and removing a mechanically damaged layer has been conventionally carried out. However, in recent years, surface grinding having a high mechanical accuracy and a high mechanical efficiency is often used.

The present inventors discovered that, when surface grinding is performed as a flattening process after a slicing process in place of lapping in manufacture of a semiconductor wafer, a heavy-metal contamination concentration of a wafer to be obtained is increased.

That is, the present inventors measured an impurity concentration of Cu with respect to each of wafers manufactured by a processing flow where lapping is carried out (slicing→lapping→etching→polishing→cleaning) and a processing flow where surface grinding is performed (slicing→surface grinding→etching→polishing→cleaning).

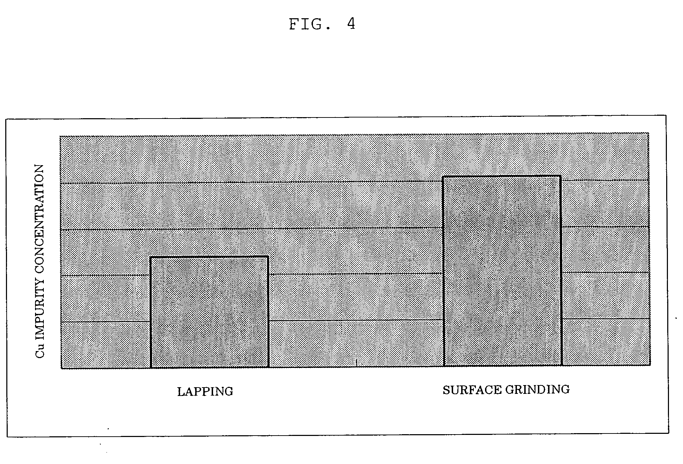

As a measurement method, a wafer surface was approximately 0.1 µm etched by using a fluorinated nitric acid, and this liquid was analyzed based on atomic absorption. FIG. 4 shows an obtained result. It can be understood from FIG. 4 that a Cu impurity concentration of the wafer obtained by flattening based on surface grinding is high. Even though the wafer is cleaned at last in each processing flow, there is a difference between Cu impurity concentrations on the obtained wafer surfaces. Therefore, it was revealed that a possibility that Cu is not only adhered to the wafer surface but also diffused into the wafer in the surface grinding process is high.

In view of such a problem, the present inventors diligently examined to obtain a surface grinding process that enables obtaining a wafer having a low Cu impurity concentration equal to that when lapping is carried out. Further, they discovered that performing a cleaning process for removing a heavy metal and then carrying out surface grinding enables obtaining a wafer having a low Cu impurity concentration, thereby bringing the present invention to completion.

That is, the surface grinding method for a semiconductor wafer according to the present invention is a method for grinding a surface of a semiconductor wafer sliced into a thin plate shape, wherein at least a cleaning process for removing a heavy metal is performed before carrying out surface grinding of the semiconductor wafer and a surface grinding process is carried out after performing the cleaning process.

Performing the cleaning process for removing a heavy metal before carrying out surface grinding of the semiconductor wafer in this manner enables carrying out surface grinding after removing the heavy metal that has adhered to the wafer. Therefore, in a process having a great mechanical effect to generate heat like surface grinding, a contaminant is not diffused into the wafer, thereby lowering a contamination level of a finally obtained wafer.

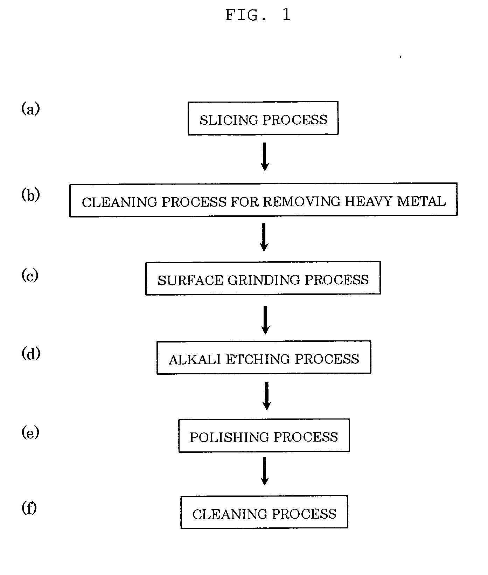

Here, FIG. 1 is a schematic view for explaining an example of a manufacturing method and a surface grinding method for a semiconductor wafer according to the present invention.
First, a silicon single crystal ingot pulled up by, e.g., a Czochralski method is sliced to be processed into a thin discoid wafer (a slicing process, FIG. 1(a)).

Subsequently, a cleaning process for removing a heavy metal that has adhered to the wafer is carried out (a cleaning process for removing a heavy metal, FIG. 1(b)). When the heavy metal that has adhered to the wafer is removed in advance by this cleaning, a contaminant does not diffuse into the wafer by surface grinding as a subsequent process. Therefore, a contamination level of the wafer can be lowered.

This cleaning process is not limited in particular, and a conventionally used process can be adopted. For example, any one or more of SC-1 cleaning, SC-2 cleaning, and cleaning using a mixture containing a citric acid and a hydrogen peroxide solution can be carried out.

A concentration of a cleaning liquid in SC-1 cleaning is not limited in particular, and 1 to 10% (capacity%) of ammonia and 1 to 10% (capacity%) of a hydrogen peroxide solution can be used, for example. Setting a chemical temperature to 60°C to 90°C is preferable.

A concentration of a cleaning liquid in SC-2 cleaning is not also limited in particular, and 1 to 10% (capacity%) of a hydrochloric acid and 1 to 10% (capacity%) of a hydrogen peroxide solution can be adopted, for example. Setting a chemical temperature to 60°C to 90°C is preferable.

Although a concentration of the mixture containing a citric acid and a hydrogen peroxide solution is not also limited in particular, a concentration of the citric acid can be set to 0.005% to 0.5% (capacity%) and a concentration of the hydrogen peroxide solution can be set to 0.01% to 1.0% (capacity%), for example. Setting a chemical temperature to 20°C to 60°C is preferable.

Although a cleaning time can be appropriately set based on a situation of the process (a situation of contamination), a chemical concentration, and a processing temperature, performing processing for 60 seconds or more enables obtaining a sufficient effect when cleaning is carried out under the above-explained cleaning conditions. When the processing time is prolonged to approximately 180 seconds, a further stable cleaning effect can be obtained. However, since the higher effect cannot be obtained when the processing time is too long, setting the processing time to 10 minutes or below is preferable.

Although a cleaning method is not limited in particular, the semiconductor wafer can be immersed in a cleaning liquid to be cleaned, for example.

Any one of the above-explained SC-1 cleaning, SC-2 cleaning, and cleaning using the mixture containing a citric acid and a hydrogen peroxide solution may be solely carried out, or two or more of these types of cleaning may be combined to be performed.

Then, the wafer is subjected to surface grinding (including double-disc grinding) in order to remove a mechanically damaged layer induced in a wafer surface layer by slicing in the slicing process and to flatten the wafer (a surface grinding process, FIG. 1(c)).

The surface grinding process can be carried out by, e.g., holding one surface of the wafer by vacuum sucking and bringing this wafer into contact with a fine diamond grinding wheel having a cup-like shape while rotating the wafer and the grinding wheel.

Furthermore, when performing double-disc grinding as the surface grinding process, grinding can be carried out by rotating the wafer while holding an outer periphery of the wafer at three points and bringing the diamond grinding wheels into contact with the wafer from both sides of the wafer.

Moreover, in order to remove a mechanical damage produced in the wafer surface layer in the above-explained process, the wafer is subjected to alkali etching (an alkali etching process, FIG. 1(d)). An etchant is not limited in particular, and etching can be performed by using, e.g., an NaOH aqueous solution or a KOH aqueous solution having a concentration of 30 to 60%.

Subsequently, a polishing process for polishing the wafer is carried out to highly flatten the surface of the wafer (FIG. 1(e)). The polishing method is not limited in particular, and a generally used method can be applied. For example, in a single-wafer processing method, the wafer is held by a polishing head and the wafer is rotated and slidingly brought into contact with a polishing turn table having a polishing pad attached thereto while supplying a polishing liquid, thereby mirror-polishing the wafer having a large diameter.

After the polishing, a cleaning process for cleaning the wafer is finally performed (FIG. 1(f)). The cleaning method is not limited in particular, and RCA cleaning as a generally used method can be applied. For example, (1) NH₄OH+H₂O₂+H₂O mixture immersion processing (1:1:5, 80°C, 10 minutes), (2) pure water rinse, (3) HF+H₂O immersion processing (containing 1% of HF), (4) pure water rinse, (5) HC1+H₂O₂+H₂O mixture immersion processing (1:1:6, 80°C, 10 minutes), (6) pure water rinse, and (7) drying can be continuously performed.

A semiconductor wafer can be obtained by the above-explained manufacturing method and surface grinding method.
In the present invention, a heavy metal that has adhered to the wafer is removed by the cleaning process, and then surface grinding is carried out. Since grinding is performed after removing a heavy metal contaminant in this manner, a heavy metal impurity is not diffused into the wafer, thereby readily obtaining a clean high-quality wafer.

It is to be noted that a lapping process or an etching process may be carried out after the slicing process, and then the cleaning process for removing the heavy metal and the surface grinding process may be performed so that the etched wafer is ground after slicing. Since the surface is active in the etching process and an etchant to be used contains a large amount of a contaminant, the contaminant may highly possibly adhere to the wafer surface. According to the surface grinding method and the manufacturing method for a semiconductor wafer of the present invention, since the heavy metal that has adhered to the wafer surface is removed by cleaning after etching and then surface grinding is carried out, a clean high-quality wafer can be readily obtained without diffusing the heavy metal impurity into the wafer.

Further, although the example where the alkali etching process, the polishing process, and the cleaning process are carried out besides the cleaning process for removing the heavy metal and the surface grinding process which are required in the present invention has been explained, these processes may be omitted. Furthermore, processes such as chamfering, lapping, cleaning, a heat treatment, and others may be added, and conventionally performed various processes, e.g., omission of some processes, counterchanging, repetitions, and others may be adopted in the present invention.

Although examples of the present invention will now be explained hereinafter, the present invention is not limited thereto.

### (Example 1)

First, a silicon single crystal ingot pulled up by the Czochralski method was sliced by using a wire saw to be processed into a thin discoid wafer (a diameter of 300 mm, a P type, an orientation <100>) (a slicing process, FIG. 1(a)).

Subsequently, a heavy metal, which adhered to the wafer, was removed by SC-1 cleaning (a cleaning process for removing the heavy metal, FIG. 1(b)). A SC-1 cleaning liquid was a mixed solution containing ammonia, a hydrogen peroxide, and pure water, and a concentration was adjusted to contain 3% (capacity%) of ammonia and 3% (capacity%) of a hydrogen peroxide solution. After adjustment, a chemical temperature was set to 80°C, and cleaning for 180 seconds was carried out. After cleaning, the wafer was rinsed with pure water, and rotated to be dried by spin drying.

Subsequently, the wafer was subjected to surface grinding in order to remove a mechanically damaged layer induced in a wafer surface layer by slicing in the slicing process and to flatten the wafer (a surface grinding process, FIG. 1(c)). Surfaces of the wafer were ground one by one by using a grinding wheel to perform double-side surface grinding.

Moreover, the wafer was subjected to alkali etching to remove a mechanical damage produced in the wafer surface layer in the above-explained process (an alkali etching process, FIG. 1(d)). An NaOH aqueous solution having a concentration of 52% was used as an etchant, and a liquid temperature was set to 80°C.

Thereafter, a polishing process for polishing the wafer was carried out (FIG. 1(e)).
At last, finish cleaning was performed based on RCA cleaning (a cleaning process, FIG. 1(f)).

### (Comparative Example 1)

As a comparative example, a slicing process, a surface grinding process, an alkali etching process, a polishing process, and a cleaning process were carried out under the same conditions as those of Example 1 except that a cleaning process for removing a heavy metal was not performed.

### (Example 2)

A slicing process was performed under the same conditions as those of Example 1.
Then, a wafer was flattened by lapping processing using loose abrasive grains (a lapping process).

Then, the wafer was etched to remove a mechanical damage produced in a wafer surface layer in the lapping process (an etching process). An NaOH aqueous solution having a concentration of 52% was used as an etchant, and a liquid temperature was set to 80°C.

Subsequently, a cleaning process for removing a heavy metal, a surface grinding process, an alkali etching process, a polishing process, and a cleaning process were carried out under the same conditions as those of Example 1.

### (Comparative Example 2)

As a comparative example, a slicing process, a lapping process, an etching process, a surface grinding process, an alkali etching process, a polishing process, and a cleaning process were carried out under the same conditions as those of Example 2 except that a cleaning process for removing a heavy metal was not performed.

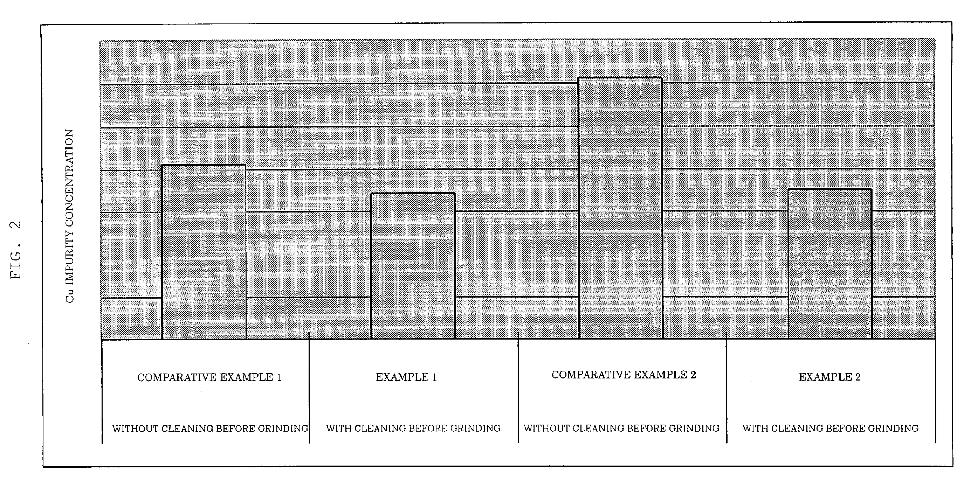

An impurity concentration of Cu was measured with respect to each of silicon wafers obtained in Examples 1, 2 and Comparative Examples 1, 2. As a measurement method, the wafer surface was approximately 0.1 µm etched by using a fluorinated nitric acid, and this liquid was analyzed based on atomic absorption. FIG. 2 shows an obtained result.

In FIG. 2, it was confirmed from each of Comparative Example 1, Example 1, Comparative Example 2, and Example 2 that the Cu impurity concentration was reduced by performing the cleaning process for removing the heavy metal before surface grinding.

### (Example 3)

A slicing process, a lapping process, an etching process, a cleaning process for removing a heavy metal, a surface grinding process, an alkali etching process, a polishing process, and a cleaning process were performed under the same conditions as those of Example 2 except that the following different three conditions were provided to cleaning liquids in the cleaning process for removing the heavy metal.

(1) An SC-1 cleaning liquid: this is a mixed solution containing ammonia, a hydrogen peroxide, and pure water, and a concentration was adjusted to contain 3% (capacity%) of ammonia and 3% (capacity%) of the hydrogen peroxide (equal to Example 2). A chemical temperature was set to 80°C, and a cleaning time was set to 180 seconds.
(2) An SC-2 cleaning liquid: this is a mixed solution containing a hydrochloric acid, a hydrogen peroxide, and pure water, and a concentration was adjusted to contain 3% (capacity%) of the hydrochloric acid and 3% (capacity%) of the hydrogen peroxide solution. A chemical temperature was set to 80°C, and a cleaning time was set to 180 seconds.
(3) A mixture containing a citric acid and a hydrogen peroxide solution: this is a mixed solution containing the citric acid, a hydrogen peroxide, and pure water (this liquid may be referred to as a citric acid/hydrogen peroxide solution hereinafter in some cases), and a concentration was adjusted to contain 0.05% (capacity%) of the citric acid and 0.1% (capacity%) of the hydrogen peroxide (H₂O₂). A chemical temperature was set to 30°C, and a cleaning time was set to 180 seconds.

### (Comparative Example 3)

The same processes as those of Comparative Example 2 were performed. That is, a cleaning process for removing a heavy metal was not performed, but a slicing process, a lapping process, an etching process, a surface grinding process, an alkali etching process, a polishing process, and a cleaning process were carried out.

### (Comparative Example 4)

As a Comparative Example 4, a slicing process, a lapping process, an alkali etching process, a polishing process, and a cleaning process were carried out in the mentioned order under the same conditions as those of Comparative Example 1 except that the lapping process was performed in place of the surface grinding process in Comparative Example 1.

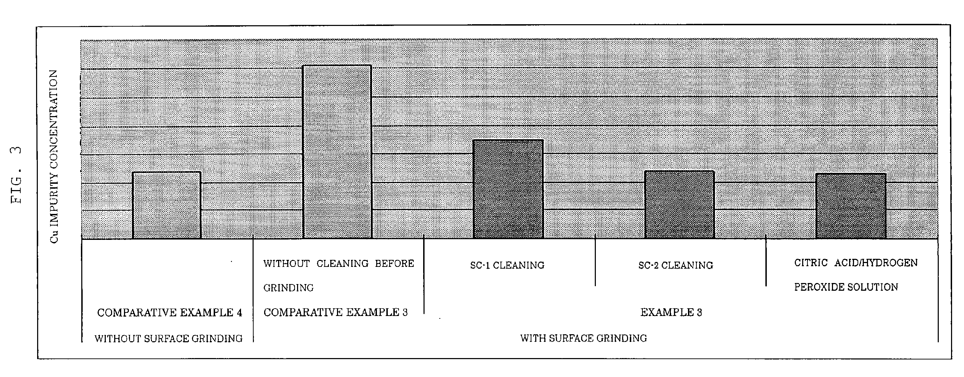

An impurity concentration of Cu was measured with respect to each of silicon wafers obtained in Example 3 and Comparative Examples 3, 4. The wafer surface was approximately 0.1 µm etched by using a fluorinated nitric acid, and this liquid was analyzed based on atomic absorption. FIG. 3 shows an obtained result.

In FIG. 3, it was confirmed from Comparative Example 3 and Example 3 that the Cu impurity concentration was reduced by performing the cleaning process for removing the heavy metal before surface grinding based on any of SC-1 cleaning, SC-2 cleaning, and citric acid/hydrogen peroxide cleaning as compared with Comparative Example 3 where cleaning was not performed before surface grinding. In particular, the Cu impurity concentration was greatly reduced when SC-2 cleaning and citric acid/hydrogen peroxide cleaning were carried out in Example 3, and it can be understood that an improvement was achieved to reach the same level as Comparative Example 4 where lapping only was carried out without performing surface grinding.

It is to be noted that the present invention is not limited to the foregoing examples. The foregoing examples are just exemplifications, and any example which has substantially the same structure as the technical ideas described in claims of the present invention and provides the similar functions and advantages is included in the technical scope of the present invention.

For example, it is needless to say that the surface grinding method and the manufacturing method according to the present invention can be applied to not only a silicon wafer but also various kinds of semiconductor wafers, e.g., a compound semiconductor.

## Claims

1. A surface grinding method for a semiconductor wafer which performs surface grinding with respect to a semiconductor wafer sliced into a thin plate shape, wherein at least a cleaning process for removing a heavy metal is performed before carrying out surface grinding of the semiconductor wafer, and a surface grinding process is carried out after performing the cleaning process.

2. The surface grinding method for a semiconductor wafer according to claim 1, wherein any one or more of SC-1 cleaning, SC-2 cleaning, and cleaning using a mixture containing a citric acid and a hydrogen peroxide solution are performed as the cleaning process for removing the heavy metal.

3. The surface grinding method for a semiconductor wafer according to claim 1 or claim 2, wherein the wafer to be ground is a wafer which is etched after slicing.

4. A manufacturing method for a semiconductor wafer comprising at least a surface grinding process, wherein at least a cleaning process for removing a heavy metal is performed before carrying out surface grinding of the semiconductor wafer, and a surface grinding process is carried out after performing the cleaning process:

5. The manufacturing method for a semiconductor wafer according to claim 4, wherein any one or more of SC-1 cleaning, SC-2 cleaning, and cleaning using a mixture containing a citric acid and a hydrogen peroxide solution are performed as the cleaning process for removing the heavy metal.

6. The manufacturing method for a semiconductor wafer according to claim 4 or claim 5, wherein the wafer to be ground is a wafer which is etched after slicing.

7. The manufacturing method for a semiconductor wafer according to any one of claims 4 to 6, wherein at least a polishing process for polishing the semiconductor wafer is performed after carrying out the surface grinding process, and a cleaning process is carried out after performing the polishing process.
